# EUROPÄISCHE PATENTSCHRIFT

(11) **EP 0 678 956 B1**
(45) Veröffentlichungstag und Bekanntmachung des Hinweises auf die Patenterteilung: **13.05.1998**
(21) Anmeldenummer: 95105423.8
(22) Anmeldetag: 11.04.1995
(51) Int. Cl.: H02B 13/065, H02B 13/035

(54) **Strom- und Spannungssensor für ein Hochspannungsfeld**
Current- and voltage sensor for a high voltage installation
Capteur de courant et tension pour une installation haute tension

(30) Priorität: 18.04.1994 DE 4412784
(43) Veröffentlichungstag der Anmeldung: 25.10.1995
(73) Patentinhaber: ABB PATENT GmbH, 68309 Mannheim (DE)
(72) Erfinder: Aufermann, Albert, D-40882 Ratingen (DE); Hennig, Ulrich, D-47800 Krefeld (DE)
(74) Vertreter: Rupprecht, Klaus, Dipl.-Ing.

(56) Entgegenhaltungen:
- DE-A- 3 313 192
- DE-A- 3 412 324
- ETZ ELEKTROTECHNISCHE ZEITSCHRIFT, Bd.114, Nr.16, August 1993, BERLIN Seiten 1000 - 1003 ALBERT AUFERMANN ET AL. 'Schaltanlagentechnik für die Zukunft'

## Beschreibung

Die Erfindung betrifft einen Strom- und Spannungssensor für ein Hochspannungsfeld gemäß dem Oberbegriff des Anspruches 1 (Vgl. DE-A- 33 13 192) sowie ein Schaltfeld mit dem Strom- und Spannungssensor gemäß dem Oberbegriff des Anspruches 13. Der Begriff Hochspannung umfaßt alle Spannungsebenen, die nicht Niederspannung sind, also Spannungsebenen der Mittelspannungs- und der Hochspannungsebene.

Aus der älteren Patentanmeldung P 43 12 620.0 ist eine elektrische Schaltanlage bekannt geworden, die einen Stromwandler aufweist, der sich zwischen dem Stromabgang eines Leistungsschalters und dem Kabelanschluß befindet. Räumlich getrennt davon ist ein Spannungswandler vorgesehen; der Stromwandler und der Spannungswandler sind beide an der Bodenfläche eines den Leistungsschalter der Schaltanlage aufnehmenden Gehäuses befestigt.

Aus der ebenfalls älteren Patentanmeldung P 43 42 796.0 ist bekannt geworden, einen Vakuumschalter innerhalb eines zylindrischen Gehäuses unterzubringen; der mit dem Kabelendverschluß elektrisch leitend verbundene Anschlußkontakt des Vakuumschalters ist von einem Stromwandler umgeben. Ein Spannungswandler ist bei der Ausführung nach der älteren Patentanmeldung nicht vorgesehen.

Aufgabe der Erfindung ist es, einen kombinierten Strom-Spannungssensor zu schaffen, der in einem Hochspannungsfeld ähnlich dem Feld einsetzbar ist, das beispielsweise in der älteren Patentanmeldung P 43 42 796.0 beschrieben ist.

Diese Aufgabe wird erfindungsgemäß gelöst durch die kennzeichnenden Merkmale des Anspruches 1.

Es ist ein zylinderförmiges Gehäuse aus gießfähigem, aushärtbarem Material, vorzugsweise Gießharz, vorgesehen, in dem der Strom- und der Spannungssensor untergebracht sind. Zu diesem Zweck besitzt das im folgenden einfach als Gießharzgehäuse bezeichnete Gehäuse an seinem einen Ende einen topfartigen Hohlraum, die mittels eines Deckels aus isolierendem oder metallischem Material abgeschlossen ist; in den topfartigen Hohlraum in dessen Bodenbereich greift ein Kontaktelement ein; zwischen dem Deckel und dem Kontaktelement ist ein den Spannungssensor bildender hochohmiger Widerstand angeordnet, wobei der hochohmige Widerstand am Kontaktelement elektrisch leitend angeschlossen ist. Der hochohmige Widerstand ist als langgestreckter Widerstand ausgebildet und verläuft in der Längsachse des zylinderförmigen Gießharzgehäuses. Innerhalb des zylinderförmgien Gießharzgehäuses befindet sich ein Stromleiter, an dem das Kontaktelement angeformt ist und der selbst wiederum als Anschluß für eine weitergehende Leitung ausgebildet ist. Um diesen Stromleiter herum ist der Stromsensor, vorzugsweise gemäß Anspruch 2 als Rogowskispule ausgebildet, herumgewickelt.

Der Stromleiter ist zylinderförmig ausgebildet und zum freien Ende des Gießharzgehäuses hin offen, so daß in den Stromleiter die Leitung einfügbar ist, wobei gemäß Anspruch 4 zur Kontaktierung zwischen dem Leiter und dem Stromleiter Multilamellenkontakte vorgesehen sind. Der Leiter kann dabei ähnlich wie in der älteren Patentanmeldung P 43 42 796.0 beschrieben ein Kontaktelement eines Leistungsschalters, vorzugsweise eines Vakuumschalters sein.

Anstatt eine Zylinderwand mit Multikontaktlamellen kann natürlich auch einfach eine Gewindebohrung vorgesehen sein, an der ein Anschluß- oder Verbindungsleiter angeschlossen ist.

Zwischen dem Kontaktelement und dem zylinderförmigen Stromleiter ist senkrecht dazu ein Stromanschluß gemäß Anspruch 6 angeformt, der als Abgangsschienenverbindung zu Kabelendverschlüssen dient.

Nach einer weiteren Ausgestaltung der Erfindung können die Mittelachse des Widerstandes und die Mittelachse des Stromleiters miteinander fluchten; es besteht auch die Möglichkeit, daß die Kontaktierungsachse in einer Achse mit dem Stromleiter und dem langgestreckten Widerstand liegen.

Gemäß einer weiteren Ausgestaltung kann der Stromleiter U-förmig ausgebildet sein, wobei der Steg mit der Mittelachse des Widerstandes fluchtet und die Kontaktierungsanordnung und das Anschlußstück senkrecht dazu aus dem Gehäuse herausragen.

Der Strom-Spannungssensor kann erfindungsgemäß bei einem Schaltfeld gemäß dem Anspruch 13 eingesetzt werden, wobei er entweder an der Bodenwand oder an der Rückwand des ersten Raumes des Schaltfeldes befestigbar ist.

Weitere vorteilhafte Ausgestaltungen der Erfindung, insbesondere des Strom- und Spannungssensors bzw. des Schaltfeldes sind den weiteren Unteransprüche zu entnehmen.

Von dem Stromwandler, also von der Rogowskispule, verläuft ein Abgangssekundärleiter hin zum freien Ende der die Vertiefung umfassenden Kragen des Gießharzgehäuses und endet dort in einem Kontaktanschluß.

Der Deckel ist, wie oben erwähnt, ebenfalls aus elektrisch isolierendem Material; in dem Deckel befindet sich ein Anschluß, der mit einem Ende des innerhalb der Vertiefung angeordneten Widerstandes verbunden ist und zu einer Datenverarbeitungs- und Signalverarbeitungseinrichtung führt.

Innerhalb des zylindrischen Kragens und radial innerhalb der Abgangssekundärleitung sind Abschirmelektroden eingebettet, von denen eine mit dem Kontaktelement und die andere mit dem deckelseitigen Ende des hochohmigen Widerstandes verbunden sind.

Anhand der Zeichnung, in der drei Ausführungsbeispiele der Erfindung dargestellt sind, sollen die Erfindung sowie weitere vorteilhafte Ausgestaltungen und Verbesserungen der Erfindung näher erläutert und beschrieben werden.

Es zeigen:
- Fig. 1: eine Schnittansicht durch eine Schaltanlage gemäß einer ersten Ausführungsform,
- Fig. 2: eine zweite Ausführungsform eines Schaltfeldes,
- Fig. 3: eine Schnittansicht durch den kombinierten Strom-Spannungssensor, der in dem Schaltfeld gemäß Fig. 1 eingebaut ist,
- Fig. 4: ein dritte Ausführungsform eines Schaltfeldes, in vertikaler Schnittansicht,
- Fig. 5: eine Längsschnittansicht durch eine dritte Ausführungsform eines kombinierten Strom- und Spannungssensor, der in der Schaltanlage Fig. 4 eingebaut ist, und
- Fig. 6: eine perspektivische Aufsicht auf den Strom- und Spannungssensor gemäß Fig. 5.

Das Schaltfeld, das in ihrer Gesamtheit die Bezugsziffer 10 hat, umfaßt mehrere Räume, nämlich einen ersten Raum 11, einen zweiten Raum 12, der vor dem ersten Raum 11 angeordnet ist, einen dritten Raum 13, der sich unterhalb des ersten 11 und zweiten Raumes 12 befindet, und einen vierten Raum 14, der oberhalb des ersten Raumes 11 und hinter dem zweiten Raum 12 befindlich ist.

Im ersten Raum 11, der ähnlich dem Raum 39 der Anlage nach der älteren Patentanmeldung P 43 42 796.0 ist, befindet sich eine der Anzahl der Phasen entsprechende Anzahl von Isoliergehäusen 15, in denen je ein Vakuumleistungsschalterpol 16 untergebracht ist, wobei jedes Isoliergehäuse 15 an der Zwischenwand 17 zwischen dem ersten und dem zweiten Raum 11, 12 festgelegt ist. Vor der Zwischenwand, also auf der Seite, die an den zweiten Raum angrenzt, befindet sich eine Trägerplatte 18, an der ein Antriebsgehäuse 19 mit Antrieben (nicht dargestellt) für die Leistungsschalterpole 16 angebracht und in dem ein Ventil 20 untergebracht ist, welches den Innenraum des Isoliergehäuses 15 mit dem ersten Raum 11 verbindet (siehe auch die ältere Patentanmeldung P 43 42 796.0).

Jeder Leistungsschalterpol 16 besitzt einen festen Kontaktstengel 21 und einen beweglichen Kontaktstengel 22, an deren im Inneren des Leistungsschalterpols 16 befindlichen Enden ein festes und ein bewegliches Kontaktstück (nicht dargestellt) angebracht ist. Über eine Kupplung 23 ist der bewegliche Kontaktstengel mit einer Antriebsstange 24, die in das Antriebsgehäuse 19 führt, verbunden. An dem beweglichen Kontaktstengel ist über ein entsprechendes Verbindungsglied 25 ein Kontaktstück 26 angeschlossen, an dem ein flexibles Band 27 außerhalb des Isoliergehäuses 15 angeschlossen ist, an dessen anderem Ende ein bewegliches Kontaktelement 28 eines Trenn- und Erdungsschalters 29 angeschlossen ist.

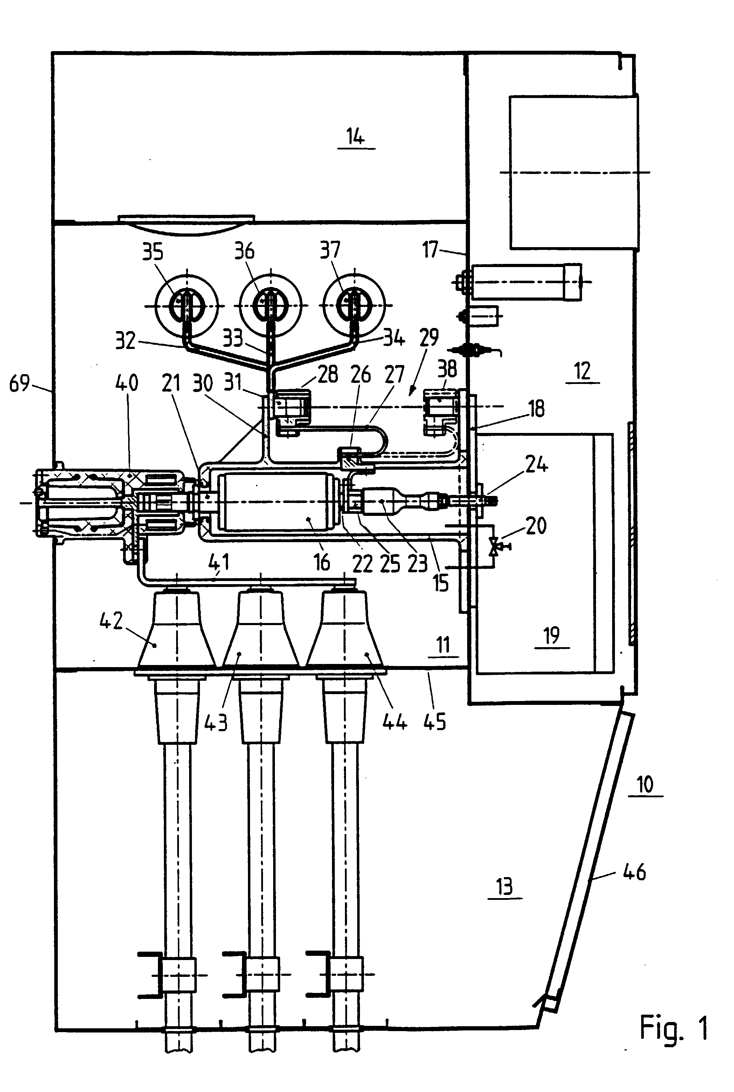

An der Außenseite des Isoliergehäuses 15 ist, senkrecht zur Mittelachse nach oben vorspringend eine Befestigungswand 30 angeformt, an der ein festes Kontaktelement 31 angebracht ist, mit dem das bewegliche Kontaktelement 28 in der in Fig. 1 dick ausgezogenen Stellung zusammenwirkt. An dem festen Kontaktelement 31 sind abgekröpfte Verbindungsleiter 32, 33 und 34 angeschlossen (natürlich jeweils ein Verbindungsleiter für jeden Leistungsschalterpol), die mit Sammelschienen 35 bis 37 in Verbindung stehen, wie auch in der Patentanmeldung P 43 42 796.0 beschrieben.

An der zum ersten Raum 11 hinweisenden Innenfläche der Zwischenwand 17 ist ein weiteres festes Kontaktelement 38 befestigt, welches über die Zwischenwand 17 geerdet ist; das bewegliche Kontaktelement 28 kann dann aus der in Fig. 1 dick ausgezogenen Stellung in die in Fig. 1 strichliert ausgezogene Stellung verbracht werden; dieses ist die Trenn- und gleichzeitig Erdungsstellung.

Der feste Kontaktstengel 21 ist über einen kombinierten Strom- und Spannungssensor 40 und über weitere Verbindungsleiter 41 mit Kabelendverschlüssen 42 bis 44 verbunden, die an der Bodenwand 45 des ersten Raumes 11 befestigt sind und in den dritten Raum, nämlich den Kabelabgangsraum 13 führen, der nach vorn hin mittels einer Tür 46 verschlossen ist.

Die in dem zweiten Raum 12 untergebrachten Elemente bzw. Komponenten sind für die Erfindung nicht von Bedeutung, so daß hierauf nicht näher eingegangen werden soll.

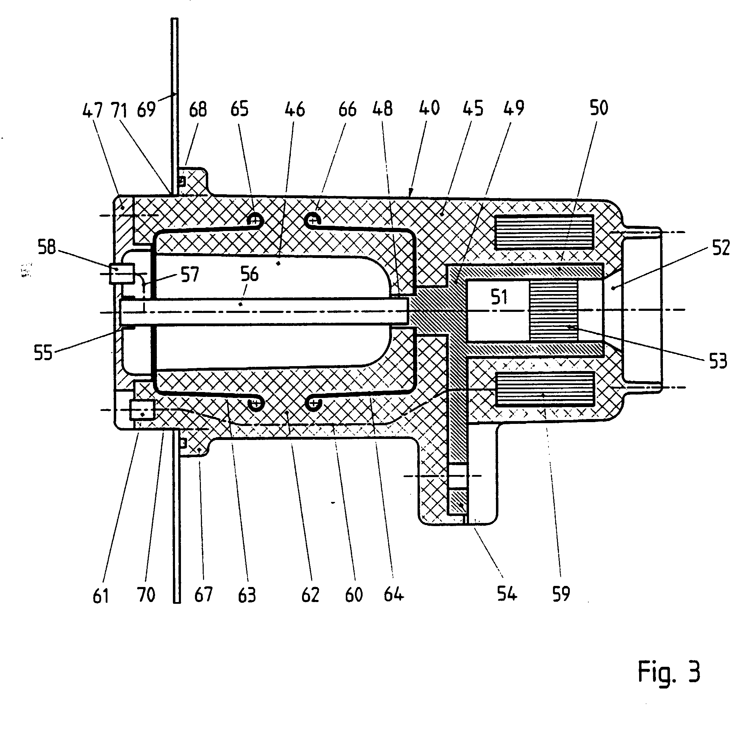

Der kombinierte Strom- und Spannungssensor für das Schaltfeld gemäß Fig. 1 ist in Fig. 3 näher dargestellt.

Er besitzt ein Gießharzgehäuse 45, welches eine zylindrische Außenkontur aufweist und an seinem Ende mit einem Hohlraum 46, im folgenden auch Vertiefung 46 genannt, versehen ist, die in der Zeichnung Fig. 3 nach links hin offen ist und mittels eines Dekkels 47 verschlossen ist. Der Deckel kann aus Metall oder auch aus isolierendem Material hergestellt sein. Am Boden der Vertiefung 46 befindet sich ein Kontaktelement 48, welches an einem Stromleiter 49 angeformt ist, der eine Zylindertopfform mit einer Zylinderwand 50 aufweist, deren Innenraum 51 nach rechts (siehe Fig. 3), also in die entgegengesetzte Richtung wie die Vertiefung über eine Öffnung 52 im Gießharzgehäuse offen ist. Innerhalb des Innenraums 51 befinden sich Multilamellenkontakte 53. Das Kontaktelement 48 ist am Boden des Stromleiters 49 angeschlossen. Senkrecht zu dem Stromleiter 49 im Bereich des Bodens des Innenraums 51 ist ein aus dem Gießharzgehäuse 45 herausragendes Anschlußstück 54 angeformt, an dem ein Verbindungsleiter 41 angeschlossen ist, siehe Fig. 1.

Auf der Innenseite besitzt der Deckel 47 eine Führungsvertiefung 55, in die ein Ende eines hochohmigen, stangenförmigen Widerstandes 56 eingesteckt ist. Das andere Ende ist in das Kontaktelement 48 eingebracht.

Der Widerstand 56 dient dabei als Spannungssensor; er ist unterteilt in einen Spannungsteiler mit einem hochspannungsseitigen und einem niederspannungsseitigen Widerstand; der niederspannungsseitige Widerstand ist das eigentliche Sensorelement. Er ist gebildet aus einer Keramikstange, um die herum ein Widerstandsdraht gewickelt ist, dessen eines Ende mit dem Kontaktelement 48 und dessen anderes Ende mit einem Leiterteilstück 47 in ein Kupplungs- oder Durchgangsstück 58 einmündet, an dem eine Signal- und Datenverarbeitungsanlage angeschlossen ist. Der Widerstand 56 dient mit dem niederspannungsseitigen Widerstansteil als Spannungssensor.

Um den Stromleiter 49 herum ist eine Rogowskispule 59 herumgewickelt; der Stromleiter 49 mit der Zylinderwand 50 dient als Primärleiter und ein von der Rogowskispule 59 wegführender Sekundärleiter 60 endet in einem weiteren Kupplungs- bzw. Anschlußstück 61 an der Stirnwand der die Vertiefung 46 umgebenden Zylinderwand 62. Mit dem Widerstand 56 und dem Kontaktelement 48 verbunden sind topfförmige Abschirmelektroden 63 und 64, deren freie Enden bei 65 und 66 umgebördelt sind und aufeinanderzuweisen; die Abschirmelektroden 63 und 64 sind dabei in das Gießharzgehäuse eingebettet und die freien Enden 65 und 66 enden in bestimmtem Abstand zueinander.

Im Bereich des Deckels 47 ist am Umfang des Gießharzgehäuses 45 ein radial vorspringender Befestigungsflansch 67 angeformt, der unter Zwischenfügung einer Dichtung 68 gegen die Rückwand 69 des ersten Raumes 11 angeschlagen ist. Das Gießharzgehäuse ragt über den Flansch 67 hinaus und durchgreift mit einem kurzen Abschnitt 70 eine Öffnung 71 in der Rückwand.

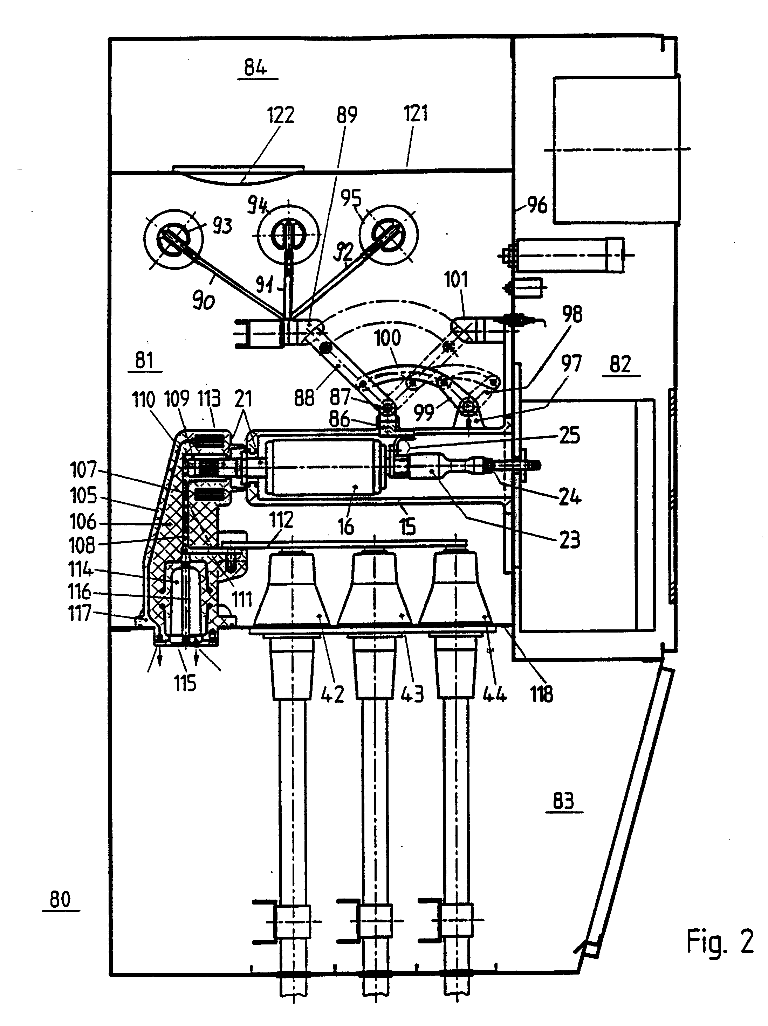

Die Fig. 2 zeigt eine weitere Ausführungsform einer erfindungsgemäßen Schaltanlage. Sie trägt die Bezugsziffer 80. Sie besitzt einen ersten Raum 81, der dem ersten Raum 11 entspricht, vor dem ersten Raum ist ein zweiter Raum 82 angeordnet, der dem zweiten Raum der Fig. 1 identisch entspricht; unterhalb des ersten und des zweiten Raumes ist ein dritter Raum 83, der dem dritten Raum 13 entspricht, vorgesehen und oberhalb des ersten Raumes 81 und hinter dem zweiten Raum 82 befindet sich ein vierter Raum 84.

Innerhalb des ersten Raumes 81 befinden sich wieder die Isoliergehäuse 15 mit den Leistungsschalterpolen 16 der Antriebskupplung 23 und der Antriebsstange 24; in gleicher Weise ist auch das Verbindungsglied 25 vorgesehen.

Dieses Verbindungsglied 25 steht mit einem Kontaktstück 86 in Verbindung, an dem senkrecht nach außen vorspringend ein Lagerelement 87 angebracht ist, an dem ein schwenkbares Schaltmesser 88 gelagert ist. Das freie Ende des schwenkbaren Schaltmessers kann in ein Einfahrkontaktstück 89 eingefahren werden, welches jeweils an Verbindungsleitern 90, 91 und 92 angeschlossen ist. Die Verbindungsleiter 90 bis 92 führen zu den Sammelschienen 35 bis 37 entsprechenden Sammelschienen 93, 94 und 95. Im Gegensatz zur Ausführung nach der Fig. 1 sind die Sammelschienen 90 und 92 V-förmig einander zugeordnet, anstatt der abgekröpften Form, wie es in Fig. 1 dargestellt ist. Entsprechend sind die Sammelschienen 93 und 95 gegenüber den Sammelschienen 35 und 37 geschwenkt.

Im Bereich der Befestigungsstelle des Isolierstoffgehäuses 15 an der vorderen Wand 96 des ersten Raumes 81 ist, auf gleicher Mantellinie wie das Kontaktstück 86, ein Lagerbock 97 befestigt, an dem ein Antriebshebel 99 gelagert ist, dessen freies Ende über einen gekrümmten Verbindungshebel 100 mit dem Schaltarm 88 verbunden ist. In der dick ausgezogenen Stellung befindet sich der Arm 99 und der Schalthebel 87 in Einschaltstellung, in der das Kontaktstück 86 mit dem Einfahrkontakt 89 verbunden ist. In der durch die Bezugsziffer 98 bezeichneten strichpunktierten Lage ist der Hebel 89 in Ausschaltstellung und der Schalthebel 88 ist mit einem Erdungskontaktstück 101, das an der Zwischenwand 96 befestigt ist, in Verbindung, so daß diese Stellung die Erdungsstellung darstellt.

Der kombinierte Strom- und Spannungssensor der in Fig. 2 die Bezugsziffer 105 trägt, besitzt ein Gießharzgehäuse 106, in das ein Stromleiter 107 eingebettet ist. Der Stromleiter 107 ist im wesentlichen U-förmig ausgebildet, wobei der Steg 108 der U-Form senkrecht zur Mittelachse des Leistungsschalterpols 16 ausgerichtet ist. Der eine Schenkel 109 ist als Zylinder ausgebildet und in montierter Stellung zum Leistungsschalterpol 16 hin offen, so daß der feste Kontaktstengel 21 in den Innenraum 110 des zylinderförmigen Schenkels 109 eingreifen kann. Der andere Schenkel 111 ist senkrecht zu dem Steg 108 ausgerichtet und ragt aus dem Gießharzgehäuse 106 heraus und gelangt mit Verbindungsleitern 112 in Verbindung, an denen jeweils Kabelendverschlüsse 42, 43 und 44 angeschlossen sind. Die Fig. 2 zeigt lediglich einen Wandler; selbstverständlich sind es drei Wandler, entsprechend der Anzahld er Phasen.

Um den zylinderförmigen Schenkel 109 herumgewickelt ist eine Rogowskispule 113, die der Rogowskispule 59 der Fig. 3 entspricht.

In gleicher Weise wie das Gießharzgehäuse gemäß Fig. 3 besitzt auch das Gießharzgehäuse 106 eine topfförmige Vertiefung (Hohlraum) 114, die von einem Deckel 115 abgeschlossen ist; zwischen dem Deckel 115 und dem Steg 108 befindet sich ein hochohmiger Widerstand 116, der dem hochohmigen Widerstand 56 entspricht. Über einen Flansch 117, der dem Flansch 67 entspricht, ist das Isolier- bzw. Gießharzgehäuse 106 an der Bodenwand 118 des ersten Raumes 81 befestigt. Die die Bezugsziffer 119 und 120 aufweisenden Anschlüsse zu den Strom- und Spannungssensorelementen, führen in den dritten Raum 83 und von dort zu Signal- und Datenverarbeitungsanlagen.

Die obere Wand 121 des ersten Raumes 81 besitzt eine Berstscheibe 122 zur Druckentlastung. Eine ähnliche Berstscheibe ist auch an der oberen Wand des Raumes 11 der Fig. 1 vorgesehen.

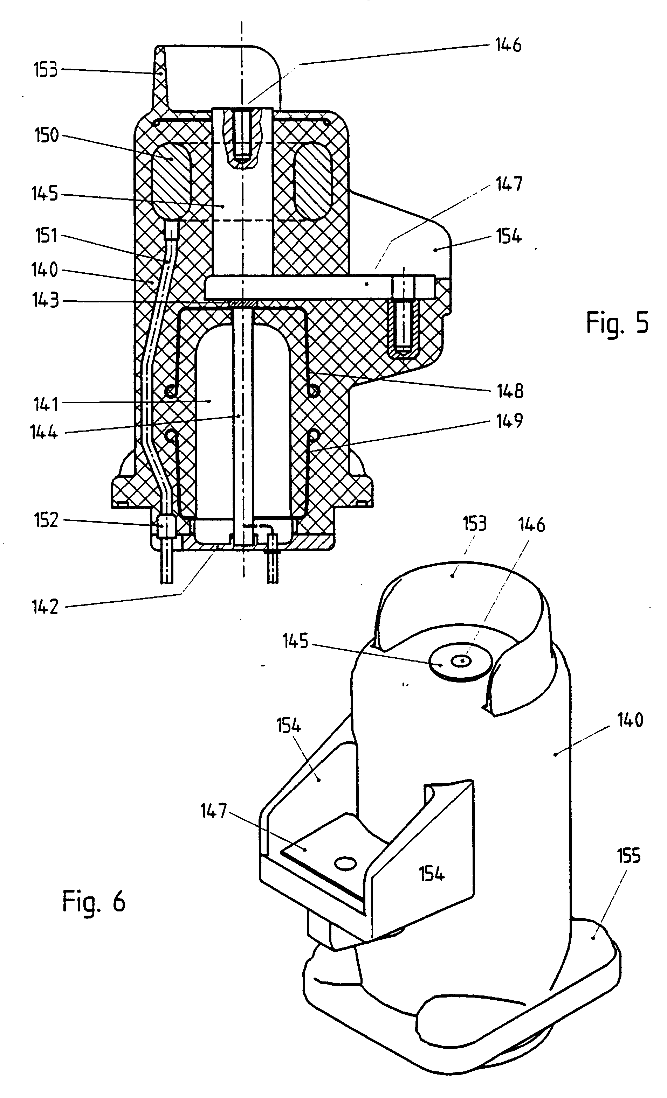

Die Fig. 5 zeigt ein Schaltfeld, das dem Schaltfeld der Fig. 2 gleicht. Innerhalb eines ersten Raumes 130, der dem Raum 81 des Schaltfeldes der Fig. 2 gleicht, befindet sich für jede Phase ein Isolierstoffgehäuse 131 mit einem Leistungsschalterpol 132, dessen fester Kontaktstengel 133 in einem in dem Isoliergehäuse 134 eingesetzten Kontaktierungselement festgehalten und kontaktiert ist. Diese Ausgestaltung ist in der gleichzeitig eingereichten Patentanmeldung P..... (Mp.-Nr. 94/560) näher beschrieben. Oberhalb jedes Isolierstoffgehäuses 131 befinden sich Trennschalter 135, die so aufgebaut und angetrieben sind, wie in der eben beschriebenen gleichrangigen Patentanmeldung.

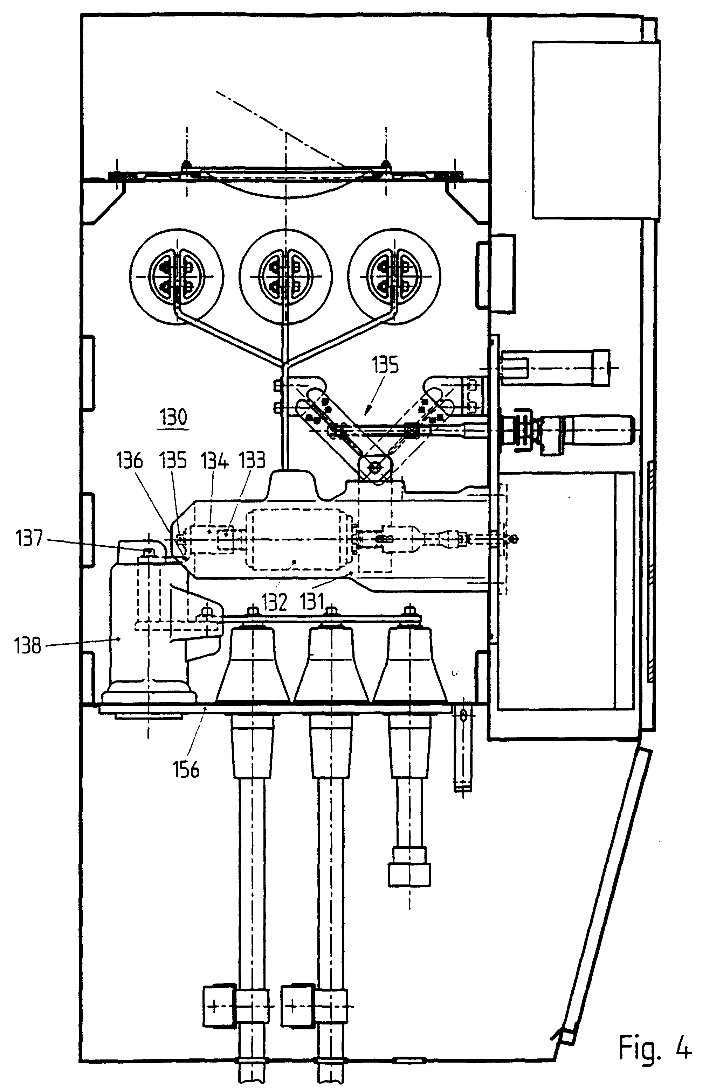

Aus dem das Gehäuse 131 durchgreifenden Kontaktierungsstück 134 ragt ein Bolzen 135 heraus, an dem ein L-förmiger Verbindungsleiter 136 angeschlossen ist, der mit einer Kontaktierungsanordnung 137 eines weiteren Strom- und Spannungssensors 138 in elektrisch leitender Verbindung steht. Dieser Strom- und Spannungssensor 138 ist näher in der Fig. 4 beschrieben. Er besitzt ein Gießharzgehäuse 140, welches ählich wie das Gießharzgehäuse 40 der Fig. 3 langgestreckt zylinderförmig ist; es besteht natürlich auch die Möglichkeit, daß das Isolierstoffgehäuse 140 ebenso wie das Isolierstoffgehäuse 40 der Ausführung nach Fig. 1 oder 3 einen quadratischen Querschnitt aufweist.

Das Isolierstoffgehäuse 40 besitzt an einem Ende einen zum Ende hin offenen Hohlraum 141, der dem Hohlraum bzw. der Vertiefung 46 entspricht und mittels eines Deckels 142 verschlossen ist. Am Boden des Hohlraumes 141 befindet sich ein Kontaktelement 143, in das ein Ende eines langgestreckten Widerstandes 144, der dem langgestreckten Widerstand 56 entspricht, eingeführt ist. Dieses Kontaktelement 143 ist an einem zylindrischen Stromleiter 145 angeschlossen, der am anderen Ende des Gießharzgehäuses 140 aus diesem geringfügig herausragt; an diesem Ende befindet sich ein Gewindesackloch 146, an dem das L-förmige Verbindungsstück 136 angeschlossen werden kann. Im Bereich des Kontaktelementes 143 befindet sich senkrecht dazu am Stromleiter 145 angeschlossen ein Anschlußstück 147, welches dem Anschlußstück 54 der Ausführung nach Fig. 3 entspricht. Der Hohlraum 141 ist von zwei Abschirmungen 148 und 149 umgeben, die in gleicher Weise ausgebildet und angeschlossen sind, wie die Abschirmungen 63 und 64 der Ausführung nach Fig. 3. Der Stromleiter 145 ist von einer Rogowskispule 150 umgeben, deren Meßleitung 151 außerhalb der Abschirmungen 148 und 149 längs durch das Gießharzgehäuse 140 hindurchgeführt ist und in gleicher Weise in einer Kupplung 152 endet, die der Kupplung 58 gemäß Fig. 3 entspricht.

Der aus dem Gießharzgehäuse herausragende Teil des Stromleiters 145 ist von einem halbkreis- und halbzylinderförmig ausgebildeten, axial vorspringenden Kragen 153 umgeben; beidseitig zu dem Anschlußleiter 147 im Bereich der Anschlußstelle befinden sich Begrenzungswände 154. In der Fig. 6 ist dies deutlich ersichtlich. Man erkennt das Gießharzgehäuse 140, die Gewindebohrung 146 des aus dem Gießharzgehäuse 140 herausragenden Stromleiters 145; der halbkreisförmige Kragen 153, der einen Zugang (in Fig. 4) von rechts zu dem Stromleiter 145 bzw. bei der Darstellung nach Fig. 6 von links vorne zuläßt, zu erkennen; beidseitig zu dem Anschlußleiter 147 sind bei der Ausführung nach Fig. 6 die beiden Begrenzungswände 154 gut zu erkennen. Das dem Deckel 142 benachbarte Ende des Gießharzgehäuses 140 besitzt einen Flansch 155, der dem Flansch 67 entspricht, damit das Gießharzgehäuse, also der kombinierte Strom-Spannungssensor an der Bodenplatte 156 des Raumes 130 befestigt werden kann.

Dieser in obiger Beschreibung dargestellte Sensor wird in allen seinen Ausgestaltungen auch als Kombisensor bezeichnet.

## Patentansprüche

1. Strom- und Spannungssensor für ein Hochspannungsschaltfeld, mit einem Gehäuse aus gießfähigem, aushärtbarem Material, vorzugsweise Gießharz, in dem der Strom- und Spannungssensor untergebracht sind, wobei das Gehäuse (45; 106) an einem Ende einen Hohlraum (46; 114) aufweist, daß am Boden des Hohlraums (46; 114) ein Kontaktelement (48) vorgesehen ist, und wobei das Kontaktelement (48) an einem im Gehäuse eingebetteten Stromleiter (48; 107) angebracht ist, an dessen freiem Ende eine Kontaktierungsanordnung vorgesehen ist, mit der ein Anschlußelement (21) beispielsweise eines Leistungsschalterpols (16) anschließbar ist und um den herum ein Stromsensor (59; 113) angeordnet ist, dadurch gekennzeichnet, daß der Hohlraum (46; 114) mit einem Deckel (47; 115) verschlossen ist, daß zwischen dem Deckel und dem Kontaktelement ein langgestreckter hochohmiger Widerstand (56; 116) als Spannungssensor vorgesehen ist.

2. Strom- und Spannungssensor nach Anspruch 1, dadurch gekennzeichnet, daß der Stromsensor (59; 113) als Rogowskispule ausgebildet ist.

3. Strom- und Spannungssensor nach Anspruch 1 oder 2, dadurch gekennzeichnet, daß die Kontaktierungsanordnung des Stromleiters (49; 107) zylinderförmig mit einer Zylinderwand (50; 109) ausgebildet ist und ein stangenförmiges Anschlußstück vorzugsweise eines Leistungsschalterpols (16) umfaßt.

4. Strom- und Spannungssensor nach Anspruch 3, dadurch gekennzeichnet, daß innerhalb der Zylinderwand (50; 109) Mulitkontaktelemente (53) vorgesehen sind.

5. Strom- und Spannungssensor nach Anspruch 1 oder 2, dadurch gekennzeichnet, daß die Kontaktierungsanordnung des zylindrischen Stromleiters (145) eine Gewindebohrung (146) ist, an der ein Verbindungsleiter (136) zu vorzugsweise einem Leistungsschalterpol angeschlossen ist.

6. Strom- und Spannungssensor nach einem der vorherigen Ansprüche, dadurch gekennzeichnet, daß im Bereich des Kontaktelementes (48) ein senkrecht zu dem langgestreckten Widerstand (56, 116) verlaufendes Anschlußstück (54; 111) angeformt ist, welches aus dem Gehäuse (45; 106) senkrecht zur Längsachse des langgestreckten Widerstandes (56) herausragt und mit Verbindungsstükken (41; 112) verbindbar ist, die zu Kabelendverschlüssen (42 bis 44) führen.

7. Strom- und Spannungssensor nach einem der vorherigen Ansprüche, dadurch gekennzeichnet, daß in der den Hohlraum (46; 114) umgebenden zylindrischen Wandung (62) Abschirmelektroden (63, 64) untergebracht sind.

8. Strom- und Spannungssensor nach einem der vorherigen Ansprüche, dadurch gekennzeichnet, daß im Bereich des freien Endes der Zylinderwandung (62) des Hohlraumes (46) ein Flanschrand (67; 117) angeformt ist, mit dem der Strom-Spannungswandler an einer Wandung (69; 118) befestigbar ist.

9. Strom- und Spannungssensor nach einem der vorherigen Ansprüche, dadurch gekennzeichnet, daß die Mittelachse des Widerstandes (56) und die Mittelachse des Stromleiters (50) miteinander fluchten.

10. Strom- und Spannungssensor nach Anspruch 9, dadurch gekennzeichnet, daß die Kontaktierungsanordnung in einer Achse mit dem Stromleiter und dem langgestreckten Widerstand liegen.

11. Strom- und Spannungssensor nach einem der Ansprüche 1 bis 8, dadurch gekennzeichnet, daß der Stromleiter (107) U-förmig ausgebildet ist, wobei der Steg (108) mit der Mittelachse des Widerstandes (116) fluchtet und die Kontaktierungsanordnung (109) und das Anschlußstück (111) senkrecht dazu aus dem Gehäuse (106) herausragen.

12. Strom- und Spannungssensor nach Anspruch 11, dadurch gekennzeichnet, daß die als Zylinderwand (109) ausgebildete Kontaktierungsanordnung senkrecht zu dem Steg (108) und parallel zum Anschlußstück (111) aus dem Gehäuse herausragen.

13. Schaltfeld mit einem Strom- und Spannungssensor nach einem der vorherigen Ansprüche 1 bis 8 und 11, mit einem ersten Raum (11, 81) der von weiteren Räumen (12, 13, 14; 82, 83, 84) druckdicht und gasdicht abgeschottet ist, wobei in dem ersten Raum Isoliergehäuse (15) zur Aufnahme der Leistungsschalterpole (16) untergebracht sind, dadurch gekennzeichnet, daß das mit dem festen Kontaktstück des Leistungsschalterpols (16) verbundene Anschlußstück (fester Kontaktstengel (21)) in den Zylinderraum (51; 110) der Kontaktierungsanordnung eingreift und daß das Gehäuse (45; 106) an der Rückwand (69) oder der Bodenwand (118) des ersten Raumes (11, 81) befestigt sind.

14. Schaltfeld mit einem Strom- und Spannungssensor nach einem der Ansprüche 9 und 10, mit einem ersten Raum (11, 81) der von weiteren Räumen (12, 13, 14; 82, 83, 84) druckdicht und gasdicht abgeschottet ist, wobei in dem ersten Raum Isoliergehäuse (15) zur Aufnahme der Leistungsschalterpole (16) untergebracht sind, dadurch gekennzeichnet, daß mit dem festen Kontaktstück des Leistungsschalterpols (16) verbundene Anschlußstück (fester Kontaktstengel (21)) mit der Kontaktierungsanordnung mittels eines L-förmigen Verbindungsleiters (136) verbunden ist und daß das Gehäuse auf der Bodenwand (156) des ersten Raumes (130) befestigt ist.

15. Schaltfeld nach Anspruch 13 oder 14, dadurch gekennzeichnet, daß der bewegliche Kontaktstengel (22) des Leistungsschalterpols über ein Verbindungsglied (25) mit einem radial an einem Isolierstoffgehäuse zur Aufnahme des Leistungsschalterpols vorspringenden Kontaktstück (26, 86) verbunden ist, an dem ein Trenn-Erdungsschalter (29, 88, 99, 100) anschließt.

16. Schaltfeld nach Anspruch 15, dadurch gekennzeichnet, daß an dem Kontaktstück (26) ein flexibles Band (27) angebracht ist, dessen anderes Ende mit einem beweglichen Kontaktelement (28) fest verbunden ist, welches einerseits mit einem mit den Verbindungsschienen (32 bis 34) verbundenen festen Kontaktstück (31) und andererseits mit einem damit fluchtenden, mit der Frontwand (17) fest verbundenen Erdungskontaktstück (38) in Verbindung bringbar ist.

17. Schaltfeld nach Anspruch 15, dadurch gekennzeichnet, daß an dem Kontaktstück (86) ein Schaltmesser (88) gelagert ist, das mittels eines Antriebsgestänges (99, 100) aus einer ersten Stellung, in der es mit Verbindungsleitern (90 bis 92) zu den Sammelschienen (93 bis 95), in einer zweiten Stellung mit einem an der Frontwand (96) befestigten Erdungskontaktstück (101) in Verbindung bringbar ist.

18. Schaltfeld nach Anspruch 17, dadurch gekennzeichnet, daß auf der Außenseite des Isolierstoffgehäuses (15) ein Lagerbock (97) befestigt ist, auf dem ein mittels einer Schaltwelle betätigbarer Hebel (99) schwenkbar gelagert ist, dessen freies Ende über einen Verbindungshebel (100) mit dem Schaltmesser (88) gekuppelt ist.

## Claims

1. Current and voltage sensor for a high-voltage switchgear panel, having a housing made from castable, curable material, preferably cast resin, in which the current and voltage sensor are accommodated, the housing (45; 106) having a cavity (46; 114) at one end, that a contact element (48) is provided on the base of the cavity (46; 114) [sic], and the contact element (48) being attached to a conductor (48; 107) which is embedded in the housing and at whose free end a contacting arrangement is provided to which a connection element (21), for example of a circuit-breaker pole (16) can be connected and around which a current sensor (59; 113) is arranged, characterized in that the cavity (46; 114) is sealed with a cover (47; 115), and in that an elongated high-value resistor (56; 116) is provided as voltage sensor between the cover and the contact element.

2. Current and voltage sensor according to Claim 1, characterized in that the current sensor (59; 113) is constructed as a Rogovski coil.

3. Current and voltage sensor according to Claim 1 or 2, characterized in that the contacting arrangement of the conductor (49; 107) is constructed cylindrically with a cylinder wall (50; 109) and comprises a bar-shaped connector preferably of a circuit-breaker pole (16).

4. Current and voltage sensor according to Claim 3, characterized in that multicontact elements (53) are provided inside the cylinder wall (50; 109).

5. Current and voltage sensor according to Claim 1 or 2, characterized in that the contacting arrangement of the cylindrical conductor (145) is a threaded bore (146) to which a connecting conductor (136) leading preferably to a circuit-breaker pole is connected.

6. Current and voltage sensor according to one of the preceding claims, characterized in that there is integrally formed in the region of the contact element (48) a connector (54; 111) which extends perpendicular to the elongated resistor (56; 116), projects from the housing (45; 106) perpendicular to the longitudinal axis of the elongated resistor (56), and can be connected to connectors (41; 112) which lead to cable terminal heads (42 to 44).

7. Current and voltage sensor according to one of the preceding claims, characterized in that screening electrodes (63, 64) are accommodated in the cylindrical wall (62) surrounding the cavity (46; 114).

8. Current and voltage sensor according to one of the preceding claims, characterized in that integrally formed in the region of the free end of the cylindrical wall (62) of the cavity (46) is a flange edge (67; 117) through which the current and voltage sensor can be fastened on a wall (69; 118).

9. Current and voltage sensor according to one of the preceding claims, characterized in that the central axis of the resistor (56) and the central axis of the conductor (50) are aligned with one another.

10. Current and voltage sensor according to Claim 9, characterized in that the contacting arrangement lie [sic] on one axis with the conductor and the elongated resistor.

11. Current and voltage sensor according to one of Claims 1 to 8, characterized in that the conductor (107) is constructed in a U-shape fashion, the web (108) being aligned with the central axis of the resistor (116), and the contacting arrangement (109) and the connector (111) projecting perpendicular thereto from the housing (106).

12. Current and voltage sensor according to Claim 11, characterized in that the contacting arrangement constructed as a cylindrical wall (109) project [sic] from the housing perpendicular to the web (108) and parallel to the connector (111).

13. Switchgear panel having a current and voltage sensor according to one of the preceding Claims 1 to 8 and 11, having a first compartment (11, 81) which is partitioned off in a pressure-tight and gas-tight fashion from further compartments (12, 13, 14; 82, 83, 84), insulating housings (15) for holding the circuit-breaker poles (16) being accommodated in the first compartment, characterized in that the connector (fixed contact stem (21)) connected to the fixed contact piece of the circuit-breaker pole (16) engages in the cylindrical compartment (51; 110) of the contacting arrangement, and in that the housing (45; 106) are [sic] fastened to the rear wall (69) or the floor (118) of the first compartment (11, 81).

14. Switchgear panel having a current and voltage sensor according to one of Claims 9 and 10, having a first compartment (11, 81) which is partitioned off in a pressure-tight and gas-tight fashion from further compartments (12, 13, 14; 82, 83, 84), insulating housings (15) for holding the circuit-breaker poles (16) being accommodated in the first compartment, characterized in that (lacuna) connector (fixed contact stem (21)) connected to the fixed contact piece of the circuit-breaker pole (16) is connected to the contacting arrangement by means of an L-shaped connecting conductor (136), and in that the housing is fastened to the floor (156) of the first compartment (130).

15. Switchgear panel according to Claim 13 or 14, characterized in that the movable contact stem (22) of the circuit-breaker pole is connected via a connecting member (25) to a contact piece (26, 86) which projects radially on an insulating housing in order to hold the circuit-breaker pole and to which a disconnecting earthing switch (29, 88, 99, 100) is connected.

16. Switchgear panel according to Claim 15, characterized in that attached to the contact piece (26) is a flexible strip (27) whose other end is firmly connected to a movable contact element (28) which can be connected, on the one hand, to a fixed contact piece (31) connected to the connecting bars (32 to 34) and, on the other hand, to an earthing contact piece (38) which is aligned with said contact piece (31) and is firmly connected to the front wall (17).

17. Switchgear panel according to Claim 15, characterized in that mounted on the contact piece (86) is a switch blade (88) which, by means of a drive linkage (99, 100), can be connected from a first position, in which connected to connecting conductors (90 to 92) to the busbars (93 to 95), in a second position to an earthing contact piece (101) fastened to the front wall (96) [sic].

18. Switchgear panel according to Claim 17, characterized in that fastened to the outside of the insulating housing (15) is a bearing block (97) on which there is pivotably mounted a lever (99) which can be actuated by means of an actuating shaft whose free end is coupled via a connecting lever (100) to the switch blade (88).

## Revendications

1. Détecteur de courant et de tension pour un tableau de distribution à haute tension, comportant un boîtier en une matière moulable, durcissable, de préférence en résine moulée, dans lequel le détecteur de courant et de tension est logé, le boîtier (45; 106) présentant à une extrémité une cavité (46; 114) et un élément de contact (48) étant prévu au fond de la cavité (46; 114), l'élément de contact (48) étant monté sur un conducteur de courant (48; 107) noyé dans le boîtier, à l'extrémité libre duquel il est prévu un dispositif de contact auquel peut être connecté un élément de connexion (21), par exemple d'un pôle de commutateur de puissance (16), et autour duquel est disposé un détecteur de courant (59; 113), caractérisé par le fait que la cavité (46; 114) est fermée par un couvercle (47; 115) et par le fait qu'une résistance à forte valeur ohmique (56; 116) allongée est prévue en tant que détecteur de tension entre le couvercle et l'élément de contact.

2. Détecteur de courant et de tension selon la revendication 1, caractérisé par le fait que le détecteur de courant (59; 113) est réalisé sous la forme d'une bobine de Rogowski.

3. Détecteur de courant et de tension selon la revendication 1, caractérisé par le fait que le dispositif de contact du conducteur (49; 107) a une forme cylindrique avec une paroi de cylindre (50; 109) et comprend une pièce de connexion en forme de tige, de préférence d'un pôle de commutateur de puissance (16).

4. Détecteur de courant et de tension selon la revendication 3, caractérisé par le fait qu'un élément à contacts multiples (53) est prévu à l'intérieur de la paroi de cylindre (50; 109).

5. Détecteur de courant et de tension selon la revendication 1 ou 2, caractérisé par le fait que le dispositif de contact du conducteurs (145) cylindrique est un trou taraudé (146) auquel est connecté un conducteur de liaison (136) menant de préférence à un pôle de commutateur de puissance.

6. Détecteur de courant et de tension selon une des revendications précédentes, caractérisé par le fait qu'une pièce de contact qui s'étend perpendiculairement à la résistance allongée (56, 116) est aménagée dans la région de l'élément de contact (48), laquelle pièce de contact fait saillie hors du boîtier (45; 106) perpendiculairement à l'axe longitudinal de la résistance allongée (56) et peut être reliée à des pièces de liaison (41; 112) qui mènent à des têtes de câbles (42 à 44).

7. Détecteur de courant et de tension selon une des revendications précédentes, caractérisé par le fait que des électrodes de blindage (63, 64) sont logées dans la paroi (62) cylindrique qui entoure la cavité (46; 114).

8. Détecteur de courant et de tension selon une des revendications précédentes, caractérisé par le fait qu'un bord formant bride (67; 117) à l'aide duquel le convertisseur courant-tension peut être fixé à une paroi (69; 118) est aménagé dans la région de l'extrémité libre de la paroi de cylindre (62) de la cavité (46).

9. Détecteur de courant et de tension selon une des revendications précédentes, caractérisé par le fait que l'axe médian de la résistance (56) et l'axe médian du conducteur (50) coïncident.

10. Détecteur de courant et de tension selon la revendication 9, caractérisé par le fait que le dispositif de contact est situé sur le même axe que le conducteur et la résistance allongée.

11. Détecteur de courant et de tension selon une des revendications 1 à 8, caractérisé par le fait que le conducteur (107) a une forme de U, la base (108) étant alignée avec l'axe médian de la résistance (116) et le dispositif de contact (109) ainsi que la pièce de contact (111) faisant saillie hors du boîtier (106) perpendiculairement à ceux-ci.

12. Détecteur de courant et de tension selon la revendication 11, caractérisé par le fait que le dispositif de contact conformé en paroi de cylindre (109) fait saillie hors du boîtier perpendiculairement à l'âme (108) et parallèlement à la pièce de connexion (111).

13. Détecteur de courant et de tension selon une des revendications précédentes 1 à 8 et 11, comportant une première chambre (11; 81) qui est séparée de manière étanche à la pression et au gaz vis-à-vis des autres chambres (12, 13, 14; 82, 83, 84), des boîtiers isolants (15) destinés à recevoir les pôles de commutateur de puissance (16) étant disposés dans la première chambre, caractérisé par le fait que la pièce de connexion (tige de contact fixe (21)) liée à la pièce de contact fixe du pôle de commutateur de puissance (16) pénètre dans la chambre cylindrique (51; 110) du dispositif de contact et par le fait que le boîtier (45; 106) est fixé à la paroi arrière (69) ou à la paroi de fond (118) de la première chambre (11, 81).

14. Détecteur de courant et de tension selon une des revendications 9 et 10, comportant une première chambre (11; 81) qui est séparée de manière étanche à la pression et au gaz vis-à-vis des autres chambres (12, 13, 14; 82, 83, 84), des boîtiers isolants (15) destinés à recevoir les pôles de commutateur de puissance (16) étant disposées dans la première chambre, caractérisé par le fait que la pièce de connexion (tige de contact fixe (21)) liée à la pièce de contact fixe du pôle de commutateur de puissance (16) est reliée au dispositif de contact à l'aide d'un conducteur de liaison (136) en forme de L et par le fait que le boîtier est fixé à la paroi de fond (156) de la première chambre (130).

15. Détecteur de courant et de tension selon la revendication 13 ou 14, caractérisé par le fait que la tige de contact mobile (22) du pôle de commutateur de puissance est reliée par l'intermédiaire d'un élément de liaison (25) à une pièce de contact (26, 86) qui fait saillie radialement sur un boîtier en une matière isolante recevant le pôle de commutateur de puissance et à la laquelle est connecté un sectionneur de mise à la terre (29, 88, 99, 100).

16. Détecteur de courant et de tension selon la revendication 15, caractérisé par le fait qu'un ruban flexible (27) est monté sur la pièce de contact (26), ruban dont l'autre extrémité est reliée fermement à un élément de contact (28) mobile qui peut être amené en contact d'un côté avec une pièce de contact fixe (31) reliée aux barres de liaison (32 à 34) et de l'autre côté avec une pièce de contact de terre (3 8) alignée liée fermement à la paroi frontale (17).

17. Détecteur de courant et de tension selon la revendication 15, caractérisé par le fait qu'un couteau de commutation (88) est monté sur la pièce de contact (26), couteau qui peut être amené au moyen d'une tringlerie d'entraînement (99; 100) d'une première position assurant la liaison avec des conducteurs de liaison (90 à 92) menant aux barres omnibus (93 à 95) dans une deuxième position de contact avec une pièce de contact de terre (101) fixée à la paroi frontale (96).

18. Détecteur de courant et de tension selon la revendication 17, caractérisé par le fait qu'un palier support (97) est fixé à la face extérieure du boîtier isolant (15), palier support dans lequel un levier (99) actionné par un arbre de commutation dont l'extrémité libre est couplée au couteau de commutateur (88) par l'intermédiaire d'un levier de liaison (100) est monté pivotant.
